# EUROPEAN PATENT SPECIFICATION

(11) **EP 1 491 868 B1**
(45) Date of publication and mention of the grant of the patent: **20.12.2006**
(21) Application number: 04252079.1
(22) Date of filing: 07.04.2004
(51) Int. Cl.: G01J 5/06, H01L 23/38, F25B 21/02

(54) **Cooled opto-electric detector**
Gekühlter opto-elektrischer Detektor
Détecteur opto-électrique refroidi

(30) Priority: 26.06.2003 KR 2003042130
(43) Date of publication of application: 29.12.2004
(73) Proprietor: SAMSUNG ELECTRONICS CO., LTD., Suwon-si, Gyeonggi-do (KR)
(72) Inventor: Hwang, In-duk, Suwon-si, Gyeonggi-do (KR); Yoon, Gil-won, Seongdong-gu, Seoul (KR); Jeon, Kye-jin, Jangan-gu, Suwon-si, Gyeonggi-do (KR)
(74) Representative: Greene, Simon Kenneth

(56) References cited:
- US-A- 5 918 469
- US-B1- 6 230 497
- US-B1- 6 509 520

## Description

The present invention relates to an opto-electric signal detector including a cooling device which can precisely control the temperature of the opto-electric signal detector.

Infrared radiation (IR) sensors are very sensitive to their temperatures. The response sensitivity and wavelength of IR sensors vary even with a slight change in temperature. Hence, accurate signal detection can be achieved by highly precise control of the temperature of IR sensors. However, non-cooled TO can-type sensor packages, in which no electronic cooling modules for temperature control are built, adopt an indirect cooling system by installing a separate cooling unit outside the sensor packages. Accordingly, non-cooled TO can-type sensor packages incompletely contact the surface of the cooling unit and thus cannot properly transmit heat to the cooling unit. Also, in TO can-type sensor packages, a temperature sensing probe is indirectly fixed to a heat transmission block and thus cannot accurately sense the temperature of the TO can-type sensor packages.

For example, to measure the concentration of glucose included in the blood of a human, the light sources of a specific band including a wavelength band highly absorptive to glucose and a wavelength band lowly absorptive to glucose is needed. A TO can-type sensor package, measures the amount of light reflected or transmitted by the human body. With the statistical analysis of a difference between the amounts of lights in two wavelength bands absorbed to glucose, the glucose concentration of human body is calculated.

However, the absorption spectrum varies very slightly with a change in the glucose concentration. Accordingly, a change in the absorption spectrum according to a change in the temperature of the sensor must be less than that according to a change in the glucose concentration. As a result, the temperature of the sensor must be precisely adjusted to a target temperature.

U.S. Patent No. 5,041,727 discloses a spectrophotometer in which a temperature control unit holds a PbS near infrared TO can-type sensor at a temperature lower than the room temperature. The spectrophotometer includes a closed housing in which a temperature sensing element is disposed in the vicinity of the PbS near infrared TO can-type sensor. Accordingly, the spectrophotometer must further include an unnecessary closed housing. In the spectrophotometer, an electronic cooling module is disposed underneath the sensor, and consequently, the state of thermal coupling of the electronic cooling module to the TO can-type sensor is improved. However, because a sensor probe for monitoring the temperature of the TO can-type sensor is disposed directly on a substrate of the electronic cooling module, the temperature of the TO can-type sensor cannot be accurately detected.

U.S. Patent No. 6,509,520 discloses a thermoelectric cooler for an infrared detector. The thermoelectric cooler and the infrared detector are enclosed between a ceramic package and a germanium window.

U.S. Patent No. 6,230,497 discloses a temperature monitoring and controlling apparatus for a semiconductor circuit. The apparatus comprises a cooling section connected to a controller. The cooling section comprises a plurality of thermoelectric cooler cells.

According to the invention, an opto-electric signal detector comprising an electronic cooling device having a first plate at a heat-absorption side of the device, a second plate at a heat-emission side of the device located a predetermined distance down from the first plate, and a plurality of thermo-electric cooling elements arranged between the first and second plates; a photosensor installed on an upper surface of the first plate of the electronic cooling device, the photosensor having a photoelectric transformation element arranged to transform an optical signal into an electrical signal; and a temperature sensor installed on a bottom surface of the first plate of the electronic cooling device, characterized in that: wiring layers for electrically connecting the thermo-electric cooling elements to one another are formed on the bottom surface of the first plate, and the temperature sensor is directly connected to the wiring layers; the photosensor is a TO can type photosensor; and the first and second plates of the electronic cooling device have a plurality of through holes through which leads of the photosensor penetrate.

In an embodiment of the invention the photosensor comprises a head, in which the photoelectric transformation element is built, a base, which supports the head, and a plurality of leads, which are electrically coupled to the photoelectric transformation element and extend from the base.

The present invention thus provides an opto-electric signal detector which can effectively control the temperature of a TO can-type sensor.

The above and other features and advantages of the present invention will become more apparent by describing in detail exemplary embodiments thereof with reference to the attached drawings in which:
FIG. 1 is a schematic perspective view of an opto-electric signal detector according to an exemplary embodiment of the present invention;
FIG. 2 is a schematic cross-section view of the opto-electric signal detector of FIG. 1;
FIG. 3 is a magnified view of portion A of FIG. 2;
FIG. 4 is a schematic perspective view of an electronic cooling device used in the opto-electric signal detector of FIG. 1;
FIG. 5 is a magnified view of portion B of FIG. 4; and
FIGS. 6A and 6B are top views showing a bottom surface of a first plate and an upper surface of a second plate, respectively, of the electronic cooling device of FIG. 4.

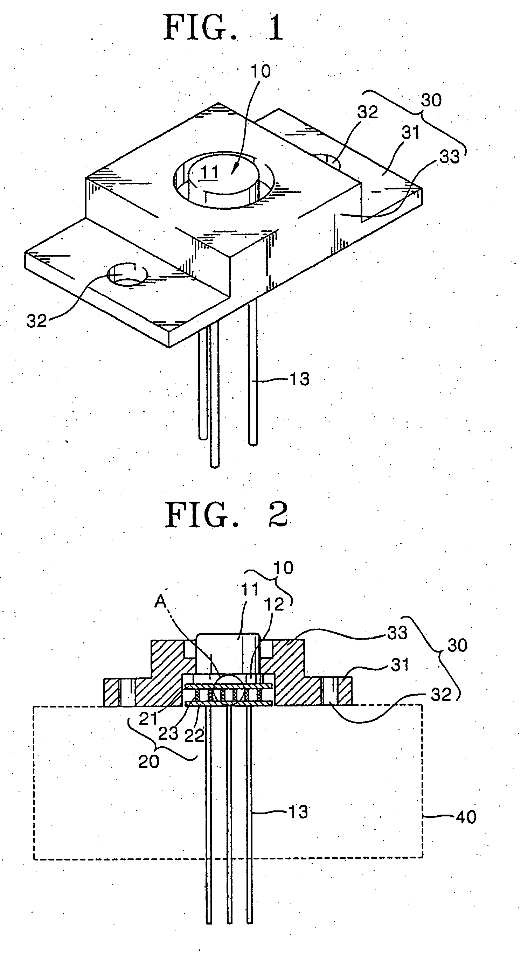

FIGS. 1 and 2 are a schematic perspective view of and a schematic cross-section view, respectively, of an opto-electric signal detector according to an exemplary embodiment of the present invention.

Referring to FIGS. 1 through 3, a TO can-type optical sensor 10 is fixed onto an electronic cooling device 20, and the TO can-type optical sensor 10 and the electronic cooling device 20 are protected by a bracket 30, which is formed of an adiabatic material.

The optical sensor 10 comprises a head 11, a base 12, and a plurality of leads 13. The head 11 has a photoelectric transformation element built-in, the base 12 supports the head 11, and the leads 13 are electrically connected to the photoelectric transformation element or the like included in the head 11 and extend down from the base 12.

The electronic cooling device 20 includes a first plate 21 at a heat-absorption side, to which the base 12 beneath the head 11 is fixed, a second plate 22 at a heat-emission side, and a plurality of thermo-electric cooling elements 23, which are arranged between the first and second plates 21 and 22.

The bracket 30 protects the head 11 and the electronic cooling device 20 installed beneath the head 11. The bracket 30 includes a body 33, which exposes the upper surface of the head 11, and a flange 31, which is formed both sides of the body 33 and has a through hole 32, into which a fastener fits.

The bracket 30 is formed of an adiabatic material having a high thermal resistance. As shown in FIG. 2, the bracket 30 is installed on a heat sink 40 so that heat from the second plate 22 at the heat-emission side of the electronic cooling device 20 can be transmitted to the heat sink 40.

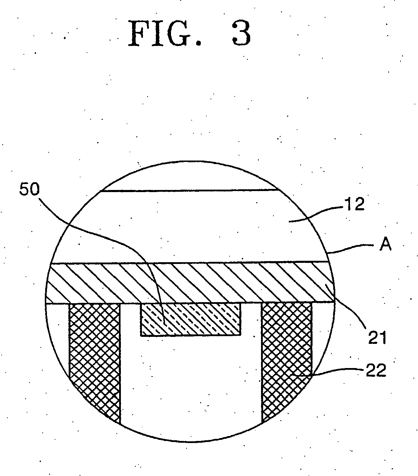

Referring to FIG. 3, a temperature sensor 50, which corresponds to a feature, of the present invention, is installed on a bottom surface of the first plate 21. In other words, the temperature sensor 50 is installed a surface of the first plate 21 other than the surface of the first plate 21 on which the photosensor 10 is installed. Hence, the temperature sensor 50 can precisely sense heat from the base 12 of the photosensor 10 that is absorbed to the first plate 21. Furthermore, because the temperature sensor 50 is placed within the electronic cooling device 20, it responds to the heat delivered to the first plate 21 and is protected from external thermal noise.

As described above, because the temperature sensor 50 is placed within the electronic cooling device 20, more specifically, beneath the first plate 21, which is easily electrically wired, the temperature sensor 50 does not need extra electric wires. In other words, wiring layers (not shown in FIGS. 1 through 3) for electrically connecting the thermo-electric cooling elements to one another are formed on the bottom surface of the first plate 21 and the upper surface of the second plate 22. While these wiring layers are being formed, wiring layers for the temperature sensor 50 can also be formed. Thus, additional formation of wiring layers or wiring for connecting these wiring layers is not required.

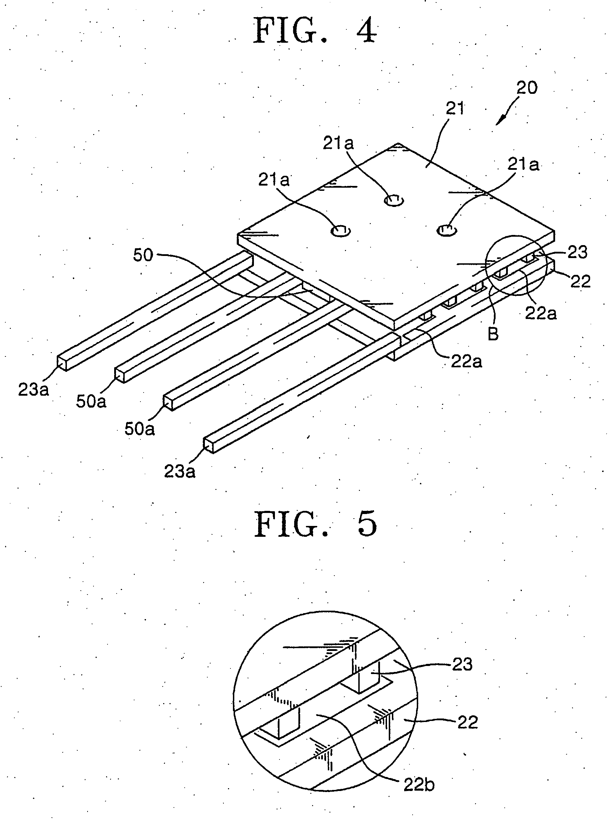

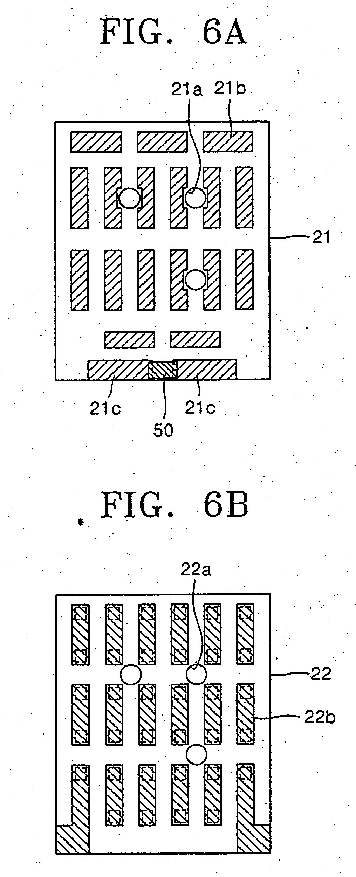

FIG. 4 is a schematic perspective view of the electronic cooling device 20 used in the opto-electric signal detector of FIG. 1. FIG. 5 is a magnified view of portion B of FIG. 4. FIG. 6A is a see-through top view illustrating the bottom surface of the first plate 21, and FIG. 6B is a top view illustrating the upper surface of the second plate 22.

Referring to FIG. 4, the electric cooling device 20 includes a pair of first leads 23a electrically connected to the thermo-electric cooling elements 23 and a pair of second leads 50a electrically connected to the thermal sensor 50. The first plate 21 has a plurality of through holes 21a, through which the leads 13 of the photosensor 10 penetrate. As shown in FIG. 6B, through holes 22a are formed in the second plate 22 so that they face the through holes 21a of the first plate 21. The thermo-electric cooling elements 23 are disposed between the first and second plates 21 and 22.

As shown in FIGS. 6A and 6B, wiring layers 21b and 22b for electrically connecting the thermo-electric cooling elements 23 to one another are formed on the bottom surface of the first plate 21 and the upper surface of the second plate 22, respectively. Also, as shown in FIG. 6A, wiring layers 21c, to which the temperature sensor 50 is coupled, are formed on the bottom surface of the first plate 21.

The first and second plates 21 and 22 are formed of an electrical insulating material, e.g., alumina Al₂O₃.

In an opto-electric signal detector according to the present invention as described above, a surface of an electronic cooling device directly contacts a base of a TO can-type photosensor so that the state of the contact between them is improved. Also, since a temperature sensor for monitoring the temperature of the photosensor is directly attached to a substrate of the electronic cooling device, more specifically, to an inside surface of a first plate, the temperature of the photosensor can be accurately sensed and adjusted to a precise target temperature.

The opto-electric signal detector according to the present invention is applicable to various fields and suitable for non-cooled IR sensor packages including no built-in temperature sensors. For example, the opto-electric signal detector is very suitable for a system which applies light to a part of a human body and measures light reflected or transmitted by the human body to invasively or noninvasively measure the concentration of body fluids. The opto-electric signal detector can also be applied to an application system similar to the above-described system.

The electrical specification of the electronic cooling device and its related elements, for example, the shapes or materials of the first and second plates, the shapes of wiring layers formed on inside surfaces of the first and second plates, and the like, are determined according to the heat capacity of the photosensor and a heat load under a working condition. The electronic cooling device having such a structure has a one-chip type hybrid temperature control circuit only for temperature control, consequently greatly improving the precision and reliability of temperature control.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. An opto-electric signal detector comprising:
an electronic cooling device (20) having a first plate (21) at a heat-absorption side of the device, a second plate (22) at a heat-emission side of the device located a predetermined distance down from the first plate, and a plurality of thermo-electric cooling elements (23) arranged between the first and second plates;
a photosensor (10) installed on an upper surface of the first plate of the electronic cooling device (20), the photosensor (10) having a photoelectric transformation element arranged to transform an optical signal into an electrical signal; and
a temperature sensor (50) installed on a bottom surface of the first plate (21) of the electronic cooling device (20),
**characterized in that**:
wiring layers (21b) for electrically connecting the thermo-electric cooling elements (23) to one another are formed on the bottom surface of the first plate (21), and the temperature sensor (50) is directly connected to the wiring layers (21b);
the photosensor (10) is a TO can type photosensor; and
the first and second plates (21, 22) of the electronic cooling device (20) have a plurality of through holes (21a, 22a) through which leads (13) of the photosensor (10) penetrate.

2. The opto-electric signal detector of claim 1, wherein the photosensor (10) comprises:
a head (11), in which the photoelectric transformation element is built;
a base (12), which supports the head; and
a plurality of leads (13), which are electrically coupled to the photoelectric transformation element and extend from the base (12).

## Patentansprüche

1. Opto-elektrischer Signaldetektor umfassend:
eine Elektronikkühlvorrichtung (20) mit einer ersten Platte (21) auf einer Wärmeabsorptionsseite der Vorrichtung, einer zweiten Platte (22) auf der Wärmeemissionsseite der Vorrichtung in einem bestimmten Abstand unter der ersten Platte gelegen und einer Mehrzahl von thermo-elektrischen Kühlelementen (23), die zwischen der ersten und zweiten Platte angeordnet sind;
einen Photosensor (10) auf einer Oberseite der ersten Platte der Elektronikkühlvorrichtung (20) installiert, wobei der Photosensor (10) ein photoelektrisches Transformationselement so angeordnet aufweist, dass ein optisches Signal in ein elektrisches Signal umgewandelt wird; und
einen Temperatursensor (50) auf einer Unterseite der ersten Platte (21) der Elektronikkühlvorrichtung (20) installiert,
**dadurch gekennzeichnet, dass**:
Leitungsschichten (21b) zum elektrischen Verbinden von thermo-elektrischen Kühlelementen (23) mit einander auf der Unterseite der ersten Platte (21) ausgebildet sind, und der Temperatursensor (50) direkt mit den Leitungsschichten (21b) verbunden ist;
der Photosensor (10) ein Photosensor vom TO-Typ ist; und
die erste und zweite Platte (21, 22) der Elektronikkühlvorrichtung (20) eine Mehrzahl von Durchtritten (21a, 22a) aufweisen, durch die Leitungen (13) des Photosensors (10) hindurchtreten.

2. Opto-elektrischer Signaldetektor nach Anspruch 1, worin der Photosensor (10) umfasst:
einen Kopf (11), in den das photoelektrische Transformationselement eingebaut ist;
eine Basis (12), die den Kopf trägt; und
eine Mehrzahl von Leitungen (13), die mit dem photoelektrischen Transformationselement elektrisch gekoppelt sind und sich von der Basis (12) erstrecken.

## Revendications

1. Détecteur de signal opto-électrique comprenant :
un dispositif de refroidissement électronique (20) présentant une première plaque (21) au niveau d'un côté d'absorption de chaleur du dispositif, une deuxième plaque (22) au niveau d'un côté d'émission de chaleur du dispositif placée à une distance prédéterminée en dessous de la première plaque, et une pluralité d'éléments de refroidissement thermo-électriques (23) agencés entre les première et deuxième plaques ;
un photodétecteur (10) monté sur une surface supérieure de la première plaque du dispositif de refroidissement électronique (20), le photodétecteur (10) possédant un élément de conversion photoélectrique prévu pour convertir un signal optique en un signal électrique ; et
un capteur de température (50) monté sur une surface inférieure de la première plaque (21) du dispositif de refroidissement électronique (20),
**caractérisé en ce que** :
des couches de câblage (21b) prévues pour connecter électriquement les éléments de refroidissement thermo-électriques (23) les uns aux autres, sont formées sur la surface inférieure de la première plaque (21), et le capteur de température (50) est directement connecté aux couches de câblage (21b) ;
le photodétecteur (10) est un photodétecteur du type TO en forme de boîtier ; et
les première et deuxième plaques (21, 22) du dispositif de refroidissement électronique (20) comportent une pluralité de trous de passage (21a, 22a) dans lesquels pénètrent des fils (13) du photodétecteur (10).

2. Détecteur de signal opto-électrique selon la revendication 1, dans lequel le photodétecteur (10) comprend :
une tête (11), dans laquelle est construit l'élément de conversion photoélectrique ;
une base (12), qui supporte la tête ; et
une pluralité de fils (13), qui sont reliés électriquement à l'élément de conversion photoélectrique et qui s'étendent en partant de la base (12).
